# EUROPEAN PATENT SPECIFICATION

(11) **EP 2 662 427 B1**
(45) Date of publication and mention of the grant of the patent: **14.03.2018**
(21) Application number: 13167334.5
(22) Date of filing: 10.05.2013
(51) Int. Cl.: C09G 1/02, H01L 21/3105

(54) **Chemical mechanical polishing composition having chemical additives and methods for using same**
Chemisch-mechanische Polierzusammensetzung mit chemischen Zusatzstoffen und Verfahren zur Verwendung davon
Composition de polissage chimique mécanique comprenant des additifs chimiques et procédés d'utilisation de celle-ci

(30) Priority: 10.05.2012 US 201261645222 P; 05.10.2012 US 201261710252 P; 15.03.2013 US 201313832234
(43) Date of publication of application: 13.11.2013
(60) Divisional application: 18153525.3
(73) Proprietor: Versum Materials US, LLC, Tempe, AZ 85284 (US)
(72) Inventor: Shi, Xiaobo, Chandler, AZ Arizona 85224 (US); Schlueter, James Allen, Phoenix, AZ Arizona 85048 (US); Graham, Maitland Gary, Phoenix, AZ Arizona 85051 (US); Stoeva, Savka I., Chandler, AZ Arizona 85226 (US); Henry, James Matthew, Mesa, AZ Arizona 85206 (US)
(74) Representative: Beck Greener

(56) References cited:
- WO-A1-2011/049216
- CN-A- 101 906 270
- JP-A- 2001 035 820
- US-A1- 2006 030 158
- US-A1- 2010 009 538
- US-A1- 2010 144 149
- US-A1- 2012 003 901
- US-B1- 6 527 622

## Description

### BACKGROUND OF THE INVENTION

This invention relates to chemical mechanical polishing compositions and methods of use the polishing compositions for polishing semiconductor substrates.

Chemical mechanical polishing (also referred to as chemical mechanical planarization, abbreviated as CMP) and chemical mechanical polishing compositions (also known as polishing slurries, polishing formulations, slurries, slurry compositions, or polishing compositions) for planarization of semiconductor substrates are now widely known to those skilled in the art.

An introductory reference on CMP is: "Chemical-Mechanical Polish" by G. B. Shinn et al., Chapter 15, pages 415-460, in Handbook of Semiconductor Manufacturing Technology, editors: Y. Nishi and R. Doering, Marcel Dekker, New York City (2000).

A semiconductor substrate, such as a wafer, or an integrated circuit, usually has one or more layers of thin films comprising different materials deposited on its surface.

In a typical CMP process, a semiconductor substrate is placed in contact with a rotating polishing pad attached to a platen. A CMP composition, typically a chemical composition having abrasives, is supplied to the pad during CMP processing. The pad, the CMP composition, and the substrate, are moved relative to one another. Thus, the CMP process accomplishes the polishing (or planarization) by chemically and mechanically interacting with the substrate, that is, concurrent chemical and mechanical abrasion of the surface of the substrate. Polishing continues until the desired thickness of the film on the substrate is removed.

Development of the next generation of semiconductor devices has emphasized the use of materials having a greater hardness and other unique properties for high-power, high-temperature, and high-frequency operation applications.

Silicon Nitride is a high strength hard material that can have a number of uses, such as an electrical insulator, a chemical diffusion barrier, a dielectric in capacitors, or an etch stop mask. Silicon carbide is a material with unique combination of electrical and thermo-physical properties, such as high practical operating temperature, good corrosion resistance, and high thermal conductivity. However, Si₃N₄ and SiC are significantly harder and chemically inert than other materials comprising an integrated circuit.

CMP for polishing semiconductor Si₃N₄ and SiC substrates has been described further in patents, patent publications and literature publications.

US6218305 disclosed a method for polishing a composite comprised of silica and silicon nitride wherein a polishing composition is used comprising: an aqueous medium, abrasive particles, a surfactant, an organic polymer viscosity modifier which increases the viscosity of the composition, and a compound which complexes with the silica and silicon nitride wherein the complexing agent has two or more functional groups each having a dissociable proton, the functional groups being the same or different.

US 2008/0057713 or US 7,678,700 taught a method of chemically-mechanically polishing a substrate comprising at least one layer of silicon carbide with a polishing composition comprising a liquid carrier, an abrasive, and an oxidizing agent.

US20100144149 disclosed a method for selectively removing silicon carbide from the surface of a substrate in preference to silicon dioxide. The method comprises abrading a surface of substrate with a polishing composition that comprises a particulate abrasive, at least one acidic buffering agent, and an aqueous carrier.

US 20100258528 taught slurry compositions and chemically activated CMP methods for polishing a substrate having a silicon carbide surface using such slurries. In such methods, the silicon carbide surface is contacted with a CMP slurry composition that comprises i) a liquid carrier; and ii) a plurality of particles having at least a soft surface portion, wherein the soft surface portion includes a transition metal compound that provides a Mohs hardness < or =6; and optionally iii) an oxidizing agent. The oxidizing agent can include a transition metal. The slurry is moved relative to the silicon carbide comprising surface, wherein at least a portion of the silicon carbide surface is removed.

US20120003901 disclosed a highly dilutable chemical mechanical polishing concentrate comprising an abrasive, an acid, a stabilizer, and water with a point-of-use pH ranging from 2.2-3.5 for planarizing current and next generation semiconductor integrated circuit FEOL/BEOL substrates.

US 8,043,970 disclosed high selectivity of polishing silicon nitride with respect to silicon oxide. The slurry compositions included an agent for reducing the oxide polishing rate.

US 6,995,090 disclosed a polishing slurry for CMP of SiC series compound film. The polishing slurry includes colloidal silica abrasive, and at least one acid selected from the group consisting of amino acid having a benzene ring and an organic acid having a heterocycle.

US 8,247,328 disclosed a method for CMP of a substrate comprising at least one layer of single crystal silicon carbide. The composition used in the method contains liquid carrier, an abrasive, a catalyst comprising a transition metal composition, and an oxidizing agent.

US 2007/0209287 taught to polish a substrate containing silicon nitride with a polishing composition comprising an abrasive and a nitride accelerator.

US 2009/0215268 disclosed a polishing composition for SiC comprised of an abrasive and an oxidizer mixed in an acidic condition.

JP2012-040671A or WO 2012/026329, described polishing composition for silicon nitride comprised of colloidal silica in which a sulfonic acid, carboxylic acid, or another such organic acid are immobilized.

US2010/0009538 disclosed a polishing composition for silicon nitride having pH of 2.5 to 5.0 comprising colloidal silica and an organic acid that has at least one sulfonic acid group or phosphonic acid group in the molecular structure.

US2008/0200033 disclosed polishing Compound, Method for Polishing Surface to be Polished, and Process for Producing Semiconductor Integrated Circuit Device.

WO 2010/065125 taught a Method for Selective polishing of Silicon carbide with respect to silicon dioxide. The method used a composition comprising abrasive, at least one acidic buffering agent, and an aqueous carrier.

US2007/0298612 taught a method for polishing silicon nitride-containing substrates using a composition comprised of colloidal silica, at least one acidic component with pKa in the range of 1 to about 4.5, and an aqueous carrier.

US 6,527,622 discloses a CMP composition for polishing noble metals comprising a) 0.5-20 % wt. of an abrasive, b) a liquid carrier, c) 0.01-10 % wt. of a polishing additive, and d) 0.5-20 % wt. of a per-type oxidizer, wherein the composition has a pH of 2 to 12, such as from 2 to 7 or 5 to 11. Exemplary polishing additives include N-2-hydroxyethylpiperazine-N'-2-ethanesulfonic acid (HEPES), or N-2-hydroxyethylpiperazine-N'3-propanesulfonic acid (EPPS), 3-(N-Morpholino)propanesulfonic acid (MOPS), N-(2-Acetamido)-2-aminoethanesulfonic acid (ACES), N-tris(hydroxymethyl)methyl-2-aminoethanesulfonic acid (TES), 3-(Cyclohexylamino)-propanesulfonic acid (CAPS), cyclohexylaminoethanesulfonic acid (CHES), and N-Tris(hydroxymethyl)methylglycine (TRICINE).

US2006/030158 discloses a composition suitable for tantalum CMP comprising, a) 0.01-5 % wt. of an abrasive, b) 0.1-10 mM of an organic oxidizer, and c) a liquid carrier. The composition preferably has a pH of 1.5 to 5. The organic oxidizer is a polishing additive that interacts with the noble metal surface and promotes its dissolution during CMP. Exemplary oxidizers include HEPES, EPPS, MOPS, ACES, TES, CHES, CAPS, N-(2-acetamido)iminodiacetic acid (ADA), and TRICINE.

JP 2001-035820 discloses a CMP composition for selective removal of silicon oide in the presence of silicon nitride. The CMP composition is preferably prepared by adding a pH buffer agent, MOPS and tetramethylammonium hydroxide to a slurry composed of cerium oxide abrasive, an acrylate-methyl acrylate copolymerised ammonium salt and water. The pH of the composition is then adjusted to 7.35.

A semiconductor substrate usually has layers made of different materials, for example, silicon nitride (Si₃N₄, or "SiN"), silicon carbide (SiC or "SiC"), silicon oxide (SiO₂) dielectric films, and/or "SiCₓN_{y}". In "SiCₓN_{y}" films, x ranges from 0.1wt% to 55wt% (or 0.001 to 0.55), y ranges from 0.1 wt% to 32 wt% (or 0.001 to 0.32). When carbon is in low concentration, the "SiCₓN_{y}" films are described as carbon doped "SiN" films; while when nitrogen is in low concentration, "SiCₓN_{y}" films are described as nitrogen doped "SiC" films.

The CMP polishing becomes more challenge, since selectivity is required to remove one material without significantly removing other materials. The development of CMP slurries for polishing Si₃N₄, SiC and /or "SiCₓN_{y}" with high removal rates, while being selective to other dielectric materials, such as silicon oxide (SiO₂), presents a formidable challenge.

Thus, there remains a need for alternative CMP compositions and methods of polishing semiconductor substrates that can provide reasonable removing rates, as well as selective polishing.

### BRIEF SUMMARY OF THE INVENTION

In one aspect, the invention provides a method of a selective chemical mechanical polishing (CMP) comprising steps of:
a) providing a semiconductor substrate having a surface containing a first material and at least one second material, wherein the first material is selected from SiC, SiN, and SiCₓN_{y} wherein x is in the range of 0.1wt% to 55wt%, and y is in the range of 0.1wt % to 32 wt%, wherein the at least one second material is selected from SiO₂ and SiN, and wherein the first material is different from the second material;
b) providing a polishing pad;
c) providing a chemical mechanical polishing composition comprising
   1) 0.05 weight % to 30 weight % abrasive;
   2) 0.025 weight % to 5 weight % chemical additive; and
   3) liquid carrier;
   wherein the chemical additive is selected from the group consisting of 4-morpholine derivatives having a general molecular structure of: 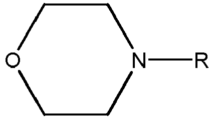 wherein R is selected from the group consisting of alkyl, alkoxy, optionally substituted organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester and organic amine; and combinations thereof; and
   the pH of the chemical mechanical polishing composition is from 2 to 8;
d) contacting the surface of the semiconductor substrate with the polishing pad and the chemical mechanical polishing composition; and
e) polishing the surface of the semiconductor substrate to selectively remove the first material;
wherein at least a portion of the surface containing the first material is in contact with both the polishing pad and the chemical mechanical polishing composition; and ratio of removal rate of the first material to removal rate of the second material is equal or greater than 1.

Preferably, the chemical additive is selected from the group consisting of 3-(N-Morpholino)propanesulfonic acid (MOPS), 4-Morpholineethanesulfonic acid (MES) and β-Hydroxy-4-morpholinepropanesulfonic acid (MOPSO) and combinations thereof.

In another aspect, the invention provides a chemical mechanical polishing composition comprising:
a) 0.05 weight % to 30 weight % abrasive;
b) 0.025 weight % to 5 weight % chemical additive; and
c) liquid carrier;
wherein the chemical additive is β-Hydroxy-4-morpholinepropanesulfonic acid (MOPSO) and the pH of the chemical mechanical polishing composition is from 2 to 8.

Preferably, at least 0.05 wt% chemical additive is present.

Suitable abrasives include, but are not limited to, alumina, ceria, germania, silica, aluminum-doped silica, titania, zirconia, and mixtures thereof.

Groups which are stated to be "optionally substituted" may be substituted or unsubstituted. Suitable substituents on substituted groups include hydroxy groups.

Particularly preferred optionally substituted organic groups with one or more hydroxyl groups include 2-hydroxyethyl and 2-hydroxy-1,1-bis(hydroxymethyl)ethyl.

Particularly preferred optionally substituted organic sulfonic acid groups include ethyl and propyl groups with a terminal sulfonic acid substituent. Optionally in the case of the propyl derived group a β-hydroxy substituent may also be present.

Particularly preferred optionally substituted organic carboxylic acid groups include 2-acetic acid. Particularly preferred optionally substituted organic amide groups include 2-acetamido.

Alkyl substituents may include cycloalkyl substituents. A preferred cycloalkyl group is cyclohexyl.

### BRIEF DESCRIPTION OF SEVERAL VIEWS OF THE DRAWINGS

Figure 1 shows the CMP removal rate effect of 4-(2-Hydroxyethyl)piperazine-1-ethanesulfonic acid (HEPES), and *N*-(2-Acetamido)-2-aminoethanesulfonic acid (ACES) on "SiC", "SiN", and silicon dioxide (TEOS).
Figure 2 shows the CMP removal rate effect of N,N-Bis(2-hydroxyethyl)-2-aminoethanesulfonic acid (BES) and *N,N*-Bis(2-hydroxyethyl)glycine (BICINE) on "SiC", "SiN", and silicon dioxide (TEOS).
Figure 3 shows the CMP removal rate of 4-(2-Hydroxyethyl)piperazine-1-ethanesulfonic acid (HEPES), 3-(N-Morpholino)propanesulfonic acid (MOPS), N,N-Bis(2-hydroxyethyl)-2-aminoethanesulfonic acid (BES) and *N*-[Tris(hydroxymethyl)methyl]glycine (TRICINE) on "SiN" and silicon dioxide (TEOS).
Figure 4 shows the CMP removal rate effect of 4-(2-Hydroxyethyl)piperazine-1-ethanesulfonic acid (HEPES), 3-(N-Morpholino)propanesulfonic acid (MOPS), N,N-Bis(2-hydroxyethyl)-2-aminoethanesulfonic acid (BES) and *N-*[Tris(hydroxymethyl)methyl]glycine (TRICINE) at two different additive concentrations on "SiN" and silicon dioxide (TEOS).

### DETAILED DESCRIPTION OF THE INVENTION

In light of the discussion above, there is a need to develop CMP compositions and methods that can provide reasonable removal rates in polishing semiconductor substrates. In addition, the CMP compositions and methods should also provide suitable removal selectivity among different types of films.

CMP compositions and associated methods described herein are effective for CMP of a wide variety of substrates. The CMP compositions and associated methods are particularly useful for polishing silicon carbide ("SiC") substrates, silicon nitride ("SiN") substrates, or "SiCₓN_{y}" substrates. "SiCₓN_{y}" substrate comprises three elements, silicon, carbon and nitrogen. In "SiCₓN_{y}" films, x ranges from 0.1wt% to 55wt%, y ranges from 0.1 wt% to 32wt %. When carbon is in low concentration, the "SiCₓN_{y}" films are described as carbon doped "SiN" films; while when nitrogen is in low concentration, "SiCₓN_{y}" films are described as nitrogen doped "SiC" films.

The silicon carbide substrate comprises at least one layer of silicon carbide. The silicon nitride substrate comprises at least one layer of silicon nitride.

Suitable substrates include, but are not limited to, flat panel displays, integrated circuits, memory or rigid disks, metals, interlayer dielectric (ILD) devices, semiconductors, micro-electro-mechanical systems, ferroelectrics, and magnetic heads.

The ratio of the removal rate of one material (the first material) to the removal rate of another material (the second material) is defined as the "selectivity" for the removal of the first material in relation to the second material. For example, the first material can be a silicon carbide film, the second material can be a silicon dioxide film. Then the selectivity for the removal of silicon carbide film to a silicon dioxide film is the ratio of the removal rate of silicon carbide film to the removal rate of silicon dioxide film.

The invention provides CMP polishing compositions containing chemical additives, and methods using CMP compositions containing chemical additives. The enhanced removal rate and the selectivity of removal are tunable by altering the chemical additives, the pH of the composition, or altering a combination of the two.

The invention provides the following key functions:
enhancing the removal rates while polishing "SiC" films,
providing afforded tunable removal rates while polishing "SiN" films,
maintaining the desirable removal rates while polishing TEOS films,
providing selectivity for the removal of "SiC" in relation to TEOS or "SiN",
providing selectivity for the removal of "SiN" in relation to TEOS,
enhancing the removal rates while polishing "SiCₓN_{y}" films,
providing afforded tunable removal rates while polishing "SiCₓN_{y}" films,
maintaining the desirable removal rates while polishing TEOS films,
providing selectivity for the removal of "SiCₓN_{y}" in relation to TEOS.

More specifically, and as noted above, the CMP compositions according to and used in the methods of the present invention comprise:
1. an abrasive;
2. a chemical additive;
3. liquid carrier.

Optionally, the CMP composition may further comprise:
4. a pH buffering agent; and/or
5. surfactant; and/or
6. biocide.

The CMP compositions have a pH value that ranges from 2.0 to 8.0. In one embodiment, the pH ranges from 2.0 to 7.5. In another embodiment, the pH ranges from 3.0 to 6.5. In yet another embodiment, the pH ranges from 4.0 to 5.5. In a further embodiment, the CMP composition has a pH value near 4.0 or near 5.0.

Suitable abrasives for this invention include, but are not limited to, alumina, ceria, germania, silica, aluminum-doped silica, titania, zirconia, and mixtures thereof. In one embodiment, the abrasive is silica such as, for example, colloidal silica or fumed silica.

In another embodiment, the abrasive is colloidal silica, the colloidal silica can be made from sodium silicate, or also can be made from tetraethylorthosilicate (TEOS) or tetramethylorthosilicate (TMOS). In yet another embodiment, the abrasive is aluminum-doped colloidal silica.

The particle size in the abrasives ranges from 5nm to 500nm, preferably from 10 to 250nm, and most preferably, from 25 to 100nm.

The abrasive level in the CMP composition ranges from 0.05 weight % (or wt%) to 30 weight % of the total weight of the polishing composition. In one particular embodiment, the abrasive level is relatively low and may ranges from 0.5% to 5% weight percent of the total weight of the polishing composition. In an alternative embodiment, the abrasive level is 2% to 4% weight percent of the total weight of the polishing composition. In a still further embodiment, the abrasive level may be ranged from 2.5% to 3.5% weight percent of the total weight of the polishing composition.

The chemical additive in the CMP composition is a removal rate enhancing agent. The CMP composition comprises 0.025 weight % to 5 weight %; more preferably 0.05 weight % to 5 weight %; chemical additive, preferably from 0.15 weight % to 1.5 weight %, and the most preferably from 0.2 weight % to 0.3 weight %.

Considering the Si-C bond is relatively inert towards reaction with the liquid carrier, for example water, the resultant network may be beneficially by interacting with chemical additives that have functional groups resulting in desired chemical and physical properties.

In the CMP compositions according to the present invention the chemical additive is β-Hydroxy-4-morpholinepropanesulfonic acid (MOPSO). In the CMP compositions used in the methods of the present invention, the chemical additive is an organic compound selected from substituted 4-morpholine derivatives.

The substituted 4-morpholine derivatives have the general molecular structure depicted below: 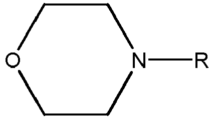 wherein, R is selected from the group consisting of alkyl, alkoxy, optionally substituted organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine, and combinations thereof.

Examples of the substituted 4- morpholine derivatives include but are not limited to 3-(N-Morpholino)propanesulfonic acid (MOPS), 4-Morpholineethanesulfonic acid (MES), and β-Hydroxy-4-morpholinepropanesulfonic acid (MOPSO).

In certain embodiments, the CMP composition, optionally, comprises about 0.005 weight % to about 5.0 weight % of an oxidizing agent. However, oxidizing agent is not used if the oxidizing agent undesirably reacts with some of the chemical additives.

The oxidizing agent can be any suitable oxidizing agent. Examples of such oxidizing agents include but are not limited to: one or more peroxy-compounds comprising at least one peroxy group (-O-O-); oxidized halides including but not limited to chlorates, bromates, iodates, perchlorates, perbromates, periodates, acids thereof, and mixtures thereof; perboric acid; perborates; percarbonates; peroxyacids including but not limited to peracetic acid, perbenzoic acid, m-chloroperbenzoic acid, salts thereof, and mixtures thereof; permanganates; chromates; cerium compounds; ferricyanides including but not limited to potassium ferricyanide; hydrogen peroxide; periodic acid; potassium iodate; potassium permanganate; ammonium persulfate; ammonium molybdate; ferric nitrate; nitric acid; potassium nitrate; and mixtures thereof.

Preferred oxidizing agents include, for example, hydrogen peroxide.

In one particular embodiment, the CMP composition may comprise (hydrogen peroxide) H₂O₂ as an alternative oxidizing agent. The concentration of H₂O₂ may be ranged from about 0.005 weight % to about 5.0 weight %, from about 0.1 weight % to about 0.25 weight % , or from about 0.15 weight % to about 0.2 weight % of the total weight of the polishing composition.

In certain embodiments, the CMP composition further comprises a pH buffering agent. The pH buffering agent is typically an acid or a base. The pH buffering agent may be used to raise or lower the pH of the CMP composition. And the pH buffering agent may be used, for example, to improve the stability of the polishing composition, improve the safety in handling and use, and/or meet the requirements of various regulations.

Suitable pH buffering agents to lower the pH of the CMP composition include, but are not limited to, hydrochloric acid, nitric acid, sulfuric acid, tartaric acid, succinic acid, citric acid, malic acid, malonic acid, various fatty acids, various polycarboxylic acids, and mixtures thereof.

Suitable pH buffering agents to raise the pH of the CMP composition include, but are not limited to, potassium hydroxide, sodium hydroxide, ammonia, tetramethylammonium hydroxide, and mixtures thereof.

In certain embodiments, the CMP composition further comprises a surfactant. The surfactant is generally used for defect reduction. The surfactant can be anionic, cationic or non-ionic. Examples of a surfactant include but are not limited to polyethylene glycol hexadecyl ether, polyethylene glycol dodecyl ether, polyethylene glycol oleyl ether and polyethylene glycol sorbitan monolaurate.

The surfactant ranges about 0.0001 weight % to about 1 weight%.

In certain embodiments, the CMP composition further comprises a biocide. The use of biocide in the enclosed CMP polishing compositions reduces or eliminates bacteria and other microorganisms, especially when the pH values of the CMP polishing compositions are close to or around neutral pH conditions.

The biocide ranges from about 0.0001 weight % to about 0.03 weight%.

Examples of a biocide include but are not limited to the commercially available Kathon family of biocides, such as, Kathon™, Kathon II, Kathon™ 886 MW Biocide, Kathon 893 MW Biocide, and Kathon CC Biocide.

In certain embodiments, the CMP composition further comprises a polymer. The polymer can be used for different purposes such as viscosity modification, defect reduction or suppression of TEOS removal rate. The polymers can have different molecular weights. Examples of a polymer include but are not limited to poly(acrylic acid), poly(ethylene oxide), poly(ethyleneimine), poly(4-vinylpyridine) and poly(vinyl alcohol).

The polymer ranges about 0.0001 weight % to about 0.5 weight%.

The rest of the composition is liquid carrier. Preferably, the liquid carrier is water; more preferably it is deionized water.

The methods of the present invention provide for the selective chemical mechanical polishing the first material in relation to the at least second material from a surface of a semiconductor substrate using the CMP compositions disclosed above.

Examples of the first material and the second material include:
the first material is "SiC" and the second material is SiO₂;
the first material is "SiN" and the second material is SiO₂;
the first material is "SiC" and the second material is "SiN"; and
the first material is "SiCₓN_{y}" and the second material is SiO₂, wherein x ranges from 0.1wt% to 55wt%, y ranges from 0.1 wt % to 32 wt %.

### Parameters

Parameters used herein are defined below.
Å: angstrom(s) - a unit of length
BP: back pressure, in psi units
CMP: chemical mechanical planarization = chemical mechanical polishing
CS: carrier speed
DF: Down force: pressure applied during CMP, units psi
min: minute(s)
psi: pounds per square inch
PS: platen rotational speed of polishing tool, in rpm (revolution(s) per minute) SF:CMP composition flow, ml/min

**Removal Rates (RR)and Selectivity**

| | |
|---|---|
| "SiC" RR 2.0 psi | Measured removal rate at 2.0 psi (13.8 kPa) down pressure of the CMP tool |
| "SiN" RR 2.0 psi | Measured removal rate at 2.0 psi (13.8 kPa) down pressure of the CMP tool |
| TEOS RR 2.0 psi | Measured removal rate at 2.0 psi (13.8 kPa) down pressure of the CMP tool |

Selectivity of "SiC" RR/"SiN" RR or "SiC" RR/TEOS RR at same down force (psi)
Type I Chemical Additive: Piperazine derivatives
Type II Chemical Additive: Substituted 4-Morpholine derivatives
Type III Chemical Additive: Organic amino sulfonic acid derivatives and their salts
Type IV Chemical Additive: Substituted amine compounds and their salts
Type V Chemical Additive: Substituted bis-amine compounds and their salts

### Working Example 1

### General Procedure

In the working examples presented below, CMP experiments were run using the procedures and under the experimental conditions given below. The CMP tool that was used in the experiments was a Mirra®, manufactured by Applied Materials, 3050 Boweres Avenue, Santa Clara, California, 95054. An IC-1010 Polishing pad, supplied by Dow Chemicals, was used on the platen for the blanket wafer polishing studies. Pads were broken-in first by performing pad conditioning break in, followed by polishing dummy oxide (deposited by plasma enhanced CVD from a TEOS precursor, abbreviated as PETEOS) wafers. A Saesol pad conditioning disk, supplied by Saesol Diamond Industries Co., LTD, was used during all pad break-in and polishing procedures.

Polishing experiments were conducted using blanket "SiC" wafer with 800 or 3000 Angstroms in thickness, "SiN" wafer and TEOS wafer. These blanket wafers were purchased from Silicon Valley Microelectronics, 1150 Campbell Ave, CA, 95126.

All percentages are weight percentages unless otherwise indicated.

The structures of some chemical additives were shown in Table 1.

**Table 1 Structures of Chemical Additive**

| Additive Name | Type of Additive* |
|---|---|
| Control | none |
| HEPES | 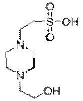 |
| PIPES | 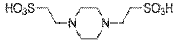 |
| EPPS | 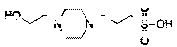 |
| MOPS | 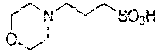 |
| TES | 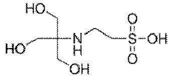 |
| ACES | 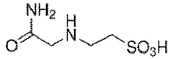 |
| BES | 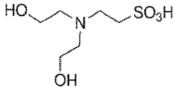 |
| Tricine | 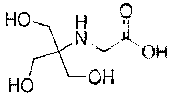 |
| Bicine | 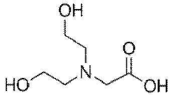 |

All CMP compositions shown in Table 2 contained 3.0wt% colloidal silica abrasive, 0.25wt% chemical additive, remainder deionized water, and pH of the CMP compositions was about 5.0. CMP composition without chemical additives was used as the baseline and designated as control in Table 2. The down force was 2 psi (13.8 kPa).

By selecting different types of chemical additives for the CMP compositions, the effect on the removal rate of silicon carbide is shown in Table 2.

**Table 2. The Chemical Additive Effects on Removal Rates of "SiC" Film**

| Additive Name | Type of Additive* | RR of "SiC" Film (Angstrom/min) | "SiC" Removal Rate% Change Compared to Control |
|---|---|---|---|
| Control | none | 600 | control |
| HEPES | Type I | 910 | +52% |
| PIPES | Type I | 863 | +44% |
| EPPS | Type I | 682 | +14% |
| MOPS | Type II | 841 | +40% |
| TES | Type III | 929 | +55% |
| ACES | Type III | 843 | +41% |
| BES | Type III | 965 | +61% |
| Tricine | Type IV | 916 | +53% |
| Bicine | Type IV | 878 | +46% |
| Bis-Tris Propane | Type V | 773 | +29% |

As shown in Table 2, the standard CMP composition (comparative) that did not contain chemical additives had an averaged "SiC" film polishing removal rate at 600 Angstrom/minute.

When a Type I additive (comparative), 4-(2-Hydroxyethyl)piperazine-1-ethanesulfonic acid(HEPES), 1,4-Piperazinediethanesulfonic acid (PIPES), or 4-(2-Hydroxyethyl)-1-piperazinepropanesulfonic acid(EPPS), was added to the polishing compositions, the "SiC" film removal rate was increased to 910 Angstrom/minute, 863 Angstrom/minute and 682 Angstrom/minute, respectively. The removal rate increasing represented about 52% removal rate increase when HEPES was used as additive, about 44% removal rate increase when PIPES was used as additive and about 14% when EPPS was used as an additive.

Also as shown in Table 2, when a Type II additive (in accordance with the invention), 4-Morpholinepropanesulfonic acid (MOPS), was added to the polishing compositions, the "SiC" film removal rates was increased to 841 Angstrom/minute. This removal rate increase represented about 40% removal rate increase compared to control when MOPS was used as additive.

Further as shown in Table 2, when a Type III additive (comparative), 2-[(2-Hydroxy-1,1-bis(hydroxymethyl)ethyl)amino]ethanesulfonic acid (TES), *N*-(2-Acetamido)-2-aminoethanesulfonic acid (ACES), or N,N-Bis(2-hydroxyethyl)-2-aminoethanesulfonic acid (BES), was added to the polishing compositions respectively, the "SiC" film removal rate was increased to 929 Angstrom/minute for TES, 843 Angstrom/minute for ACES and 965 Angstrom/minute for BES, respectively. This removal rate increase represented about 55% removal rate increase compared to control when TES was used as additive, about 41% removal rate increase when ACES was used as additive and about 61% removal rate increase when BES was used as additive.

Further as shown in Table 2, when a Type IV additive (comparative), N-[Tris(hydroxymethyl)methyl]glycine (TRICINE), or *N,N*-Bis(2-hydroxyethyl)glycine (BICINE) was added to the polishing compositions respectively, the "SiC" film removal rate was increased to 916 Angstrom/minute for TRICINE and 878 Angstrom/minute for BICINE, respectively. This removal rate increase represented about 53% removal rate increase compared to control when TRICINE was used as additive and about 46% removal rate increase when BICINE was used as additive.

It is apparent from the data presented in Table 2, that the silicon carbide removal rates were enhanced strongly when the CMP composition comprised chemical additives. The removal rates were tunable by alternating the chemical additives used in the composition.

In general, increasing the abrasive concentrations in CMP composition provides an approach to increase the removal rates of "SiC" films in a CMP process. However, increasing abrasive concentrations tends to cause more particle related defects and may cause more mechanical damages to the finished wafer surfaces Thus, CMP polishing compositions having relative low concentrations of abrasives but containing chemical additives provided a better option for enhancing the removal rates of "SiC" films.

In addition to the aforementioned benefits of enhancing "SiC" film removal rates using CMP composition containing chemical additives, tunable selectivity was also achieved while polishing multi-type of films, such as "SiC", "SiN" and silicon dioxide.

The removal rates of "SiC", "SiN" and TEOS films using different additives were listed in Table 3.

**Table 3. The Chemical Additive Effects on Removal Rates of "SiC", "SiN" and TEOS Films**

| Additive Name | Type of Additive* | RR of "SiC" Film (Angstrom/min) | RR of "SiN" Film (Angstrom/min) | RR of TEOS Film (Angstrom/min) |
|---|---|---|---|---|
| Control | none | 600 | 77 | 71 |
| HEPES | Type I | 910 | 393 | 77 |
| PIPES | Type I | 863 | 600 | 143 |
| EPPS | Type I | 682 | 338 | 94 |
| MOPS | Type II | 841 | 550 | 76 |
| TES | Type III | 929 | 276 | 73 |
| ACES | Type III | 843 | 574 | 101 |
| BES | Type III | 965 | 594 | 88 |
| Tricine | Type IV | 916 | 191 | 74 |
| Bicine | Type IV | 878 | 109 | 64 |
| Bis-Tris Propane | Type V | 773 | 530 | 187 |

The examples in Table 3 illustrated that the use of chemical additives enhanced the removal rates for all materials tested: "SiC", "SiN" and TEOS films, compared to the absence of chemical additives, i.e. with removal rates higher than the control.

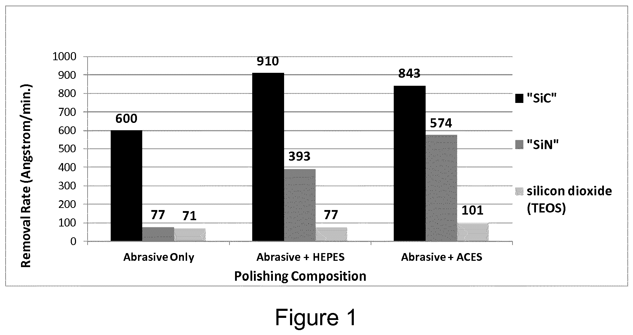

For example, as shown in Figure 1, the use of HEPES (comparative) and ACES (comparative) demonstrated the enhancement of "SiC" and "SiN" removal rates compared to the control. In addition, ACES provided greater "SiN" removal rate enhancement than HEPES compared to the control, showing the enhancement was tunable.

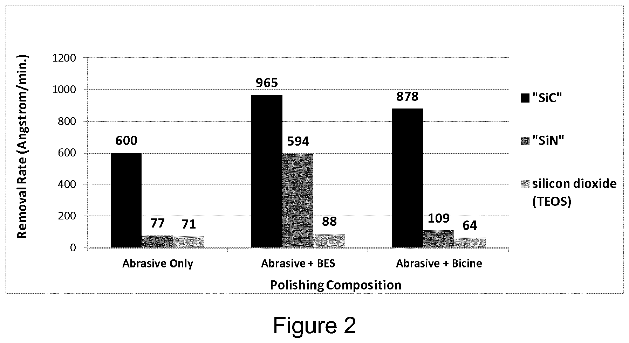

In another example, as shown in Figure 2, the use of chemical additives BES (comparative) and BICINE (comparative) both led to high "SiC" removal rates. However, the "SiN" removal rate for BES was 594 Angstrom/min, while "SiN" removal rate was 109 Angstrom/min for Bicine. Thus, BES provided much more enhancement for the "SiN" removal, again showing the enhancement was tunable.

The removal selectivities, shown as the ratio of removal rates, of "SiC"/ "SiN", "SiC"/TEOS, and "SiN"/TEOS were listed in Table 4.

As shown in Table 4, the removal selectivities were tunable (increased or decreased) depending upon the type of chemical additives been used.

For example, in the cases when HEPES (comparative), MOPS (in accordance with the invention), TES (comparative), BES (comparative), Tricine (comparative) and Bicine (comparative) were used, the selectivities of "SiC"/TEOS were higher than the control. Please note that the removal rates for "SiC" were higher than the control (shown in Table 4) for those chemical additives.

**Table 4. The Chemical Additive Effects on the Selectivity of "SiC", "SiN" and TEOS Films**

| Additive Name | Type of Additive* | Selectivity of "SiC"/"SiN" | Selectivity of "SiC"/TEOS | Selectivity of "SiN"/TEOS |
|---|---|---|---|---|
| Control | none | 7.8 | 8.5 | 1.1 |
| HEPES | Type I | 2.3 | 11.8 | 5.1 |
| PIPES | Type I | 1.4 | 6.0 | 4.2 |
| EPPS | Type I | 2.0 | 7.3 | 3.6 |
| MOPS | Type II | 1.5 | 11.1 | 7.2 |
| TES | Type III | 3.4 | 12.7 | 3.8 |
| ACES | Type III | 1.5 | 8.3 | 5.7 |
| BES | Type III | 1.6 | 11.0 | 6.8 |
| Tricine | Type IV | 4.8 | 12.4 | 2.6 |
| Bicine | Type IV | 8.1 | 13.7 | 1.7 |
| Bis-Tris Propane | Type V | 1.5 | 4.1 | 2.8 |

In another example, the enhanced "SiC" removal rate for the addition of TES (comparative) and TRICINE (comparative) were similar (929 and 916 Angstrom/min respectively, shown in Table 3). The "SiC"/TEOS removal selectivities for the two were also similar (about 12, shown in Table 4). However, the "SiC"/"SiN" removal selectivities were 3.4 and 4.8, respectively.

In another example, additives like BES (comparative) and BICINE (comparative) both led to high "SiC" removal rates (Figure 2) and high "SiC"/TEOS removal selectivities of 11 and 13.7, respectively (Table 4). However, the "SiC"/"SiN" removal selectivity for BES was 1.6 and for BICINE was 8.1, while "SiN"/TEOS removal selectivity for BES was 6.8 and for BICINE was 1.7.

Thus, the removal selectivities in Table 4 demonstrated the tunability of the selective removal of one material versus another, for CMP compositions containing different chemical additives.

In addition, tunable selectivities while polishing multi-type of films, such as "SiC", "SiN" and silicon dioxide can be further achieved by varying the pH of the polishing composition.

### Working Example 2

### General Procedure

In the working examples presented below, CMP experiments were run using the procedures and under the experimental conditions given below. The CMP tool that was used in the experiments was a Mirra®, manufactured by Applied Materials, 3050 Boweres Avenue, Santa Clara, California, 95054. An Politex polishing pad, supplied by Dow Chemicals, was used on the platen for the blanket wafer polishing studies. Pads were broken-in by polishing dummy oxide (deposited by plasma enhanced CVD from a TEOS precursor, abbreviated as PETEOS) wafers. No conditioning was used on the Politex pad.

Polishing experiments were conducted using blanket "SiN" wafer and TEOS wafer. These blanket wafers were purchased from Silicon Valley Microelectronics, 1150 Campbell Ave, CA, 95126.

All percentages are weight percentages, and data in Tables was a one time data and each number was an average of polishing two wafers, unless otherwise indicated.

All CMP compositions shown in Table 5 contained 3.0wt% aluminum-doped colloidal silica abrasive, 0.1 wt% chemical additive, remainder deionized water, and pH of the CMP compositions was about 5.5. The down force was 2 psi (13.8 kPa). CMP composition without chemical additives was used as the baseline and designated as control in Table 5. By selecting different types of chemical additives for the CMP compositions, the effect on the removal rate of silicon nitride is shown in Table 5.

**Table 5. The Chemical Additive Effects on Removal Rates of "SiN"**

| Additive Name | Type of Additive* | RR of "SiN" Film (Angstrom/min) | "SiN" Removal Rate% Change Compared to Control |
|---|---|---|---|
| Control | none | 145 | control |
| HEPES | Type I | 412 | +184% |
| MOPS | Type II | 460 | +217% |
| BES | Type III | 433 | +199% |
| Tricine | Type IV | 328 | +126% |

As shown in Table 5, the standard CMP composition that did not contain chemical additives had an average "SiN" film polishing removal rate of 145 Angstrom/min.

When a Type I additive (comparative), 4-(2-Hydroxyethyl)piperazine-1-ethanesulfonic acid (HEPES), was added to the polishing compositions, the "SiN" film removal rate was increased to 412 Angstrom/minute. The removal rate increasing represented about 184% removal rate increase when HEPES was used as additive.

Also as shown in Table 5, when a Type II additive (in accordance with the invention), 4-Morpholinepropanesulfonic acid (MOPS), was added to the polishing compositions, the "SiN" film removal rate was increased to 460 Angstrom/minute. This removal rate increase represented about 217% removal rate increase compared to control when MOPS was used as additive.

Further as shown in Table 5, when a Type III additive (comparative), N,N-Bis(2-hydroxyethyl)-2-aminoethanesulfonic acid (BES), was added to the polishing compositions, the "SiN" film removal rate was increased to 433 Angstrom/minute. This removal rate increase represented about 199% removal rate increase compared to control when BES was used as additive.

Yet, further as shown in Table 5, when a Type IV additive (comparative), N-[Tris(hydroxymethyl)methyl]glycine (TRICINE), was added to the polishing compositions respectively, the "SiN" film removal rate was increased to 328 Angstrom/minute. This removal rate increase represented about 126% removal rate increase compared to control when TRICINE was used as additive.

It is apparent from the data presented in Table 5, that the silicon nitride removal rates were enhanced strongly when the CMP composition comprised chemical additives.

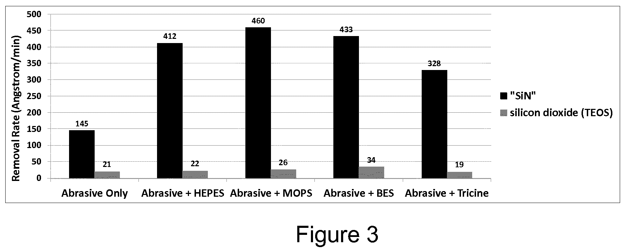

The removal rates were tunable by alternating the chemical additives used in the composition. For example, as shown in Figure 3, the use of HEPES, MOPS, BES and Tricine demonstrated the enhancement of "SiN" removal rate compared to control. In addition, HEPES, MOPS and BES provided greater "SiN" removal rate enhancement than Tricine compared to the control, showing the enhancement was tunable.

The removal rates of "SiN" and TEOS films and the removal selectivities, shown as the ratio of removal rates of "SiN"/TEOS, using different additives were listed in Table 6.

As shown in Table 6, the removal selectivities were all higher than the control when the chemical additives were used.

**Table 6. The Chemical Additive Effects on Removal Rates of "SiN"**

| Additive Name | Type of Additive* | RR of "SiN" Film (Angstrom/min) | RR of TEOS Film (Angstrom/min) | Selectivity of "SiN"/TEOS |
|---|---|---|---|---|
| Control | none | 145 | 21 | 6.9 |
| HEPES | Type I | 412 | 22 | 18.7 |
| MOPS | Type II | 460 | 26 | 17.7 |
| BES | Type III | 433 | 34 | 12.7 |
| Tricine | Type IV | 328 | 19 | 17.3 |

By selecting different types of chemical additives at two different concentrations in the CMP compositions, the effect on the removal rate of silicon nitride is shown in Table 7.

All CMP compositions shown in Table 7 contained 3.0wt% aluminum-doped colloidal silica abrasive, 0.025wt% or 0.25wt% chemical additive, remainder deionized water and pH of the CMP compositions was about 5.5. CMP composition without chemical additives was used as the baseline and designated as control in Table 7. The down force was 2 psi (13.8 kPa).

**Table 7. The Chemical Additive Effects on Removal Rates of "SiN"**

| Additive Name | Type of Additive* | Additive Concentration (wt%) | RR of "SiN" Film (Angstrom/min) | "SiN" Removal Rate% Change Compared to Control |
|---|---|---|---|---|
| Control | none | none | 67 | control |
| HEPES | Type I | 0.025 | 162 | +142% |
| | | 0.25 | 524 | +682% |
| MOPS | Type II | 0.025 | 267 | +299% |
| | | 0.25 | 473 | +606% |
| BES | Type III | 0.025 | 249 | +272% |
| | | 0.25 | 586 | +775% |
| Tricine | Type IV | 0.025 | 106 | +58% |
| | | 0.25 | 365 | +445% |

As shown in Table 7, the standard CMP composition (comparative) that did not contain chemical additives had an average "SiN" film polishing removal rate of 67 Angstrom/min. When a Type I additive (comparative), 4-(2-Hydroxyethyl)piperazine-1-ethanesulfonic acid(HEPES), was added to the polishing compositions at 0.025wt% and 0.25wt%, the "SiN" film removal rate was increased to 162 Angstrom/minute and 524 Angstrom/minute, respectively. The removal rate increasing at the 0.025wt% and 0.25wt% concentration levels of the additive represented about 142% and 682% removal rate increase, respectively when HEPES was used as additive. The removal rate increase at 0.25wt% additive was higher than the removal rate increase at 0.025wt% additive.

Also as shown in Table 7, when a Type II additive (in accordance with the invention), 4-Morpholinepropanesulfonic acid (MOPS), was added to the polishing compositions at 0.025wt% and 0.25wt%, the "SiN" film removal rate was increased to 267 Angstrom/minute and 473 Angstrom/minute, respectively. The removal rate increasing at the 0.025wt% and 0.25wt% concentration levels of the additive represented about 299% and 606% removal rate increase, respectively when MOPS was used as additive. The removal rate increase at 0.25wt% additive was higher than the removal rate increase at 0.025wt% additive.

Further as shown in Table 7, when a Type III additive (comparative), N,N-Bis(2-hydroxyethyl)-2-aminoethanesulfonic acid (BES), was added to the polishing compositions at 0.025wt% and 0.25wt%, the "SiN" film removal rate was increased to 249 Angstrom/minute and 586 Angstrom/minute, respectively. The removal rate increasing at the 0.025wt% and 0.25wt% concentration levels of the additive represented about 272% and 775% removal rate increase, respectively when BES was used as additive. The removal rate increase at 0.25wt% additive was higher than the removal rate increase at 0.025wt% additive.

Yet, further as shown in Table 7, when a Type IV additive (comparative), *N-*[Tris(hydroxymethyl)methyl]glycine (TRICINE), was added to the polishing compositions at 0.025wt% and 0.25wt%, the "SiN" film removal rate was increased to 106 Angstrom/minute and 365 Angstrom/minute, respectively. The removal rate increasing at the 0.025wt% and 0.25wt% concentration levels of the additive represented about 58% and 445% removal rate increase, respectively when BES was used as additive. The removal rate increase at 0.25wt% additive was higher than the removal rate increase at 0.025wt% additive.

It is apparent from the data presented in Table 7, consistent with Table 5, that the silicon nitride removal rates were enhanced strongly when the CMP composition comprised chemical additives.

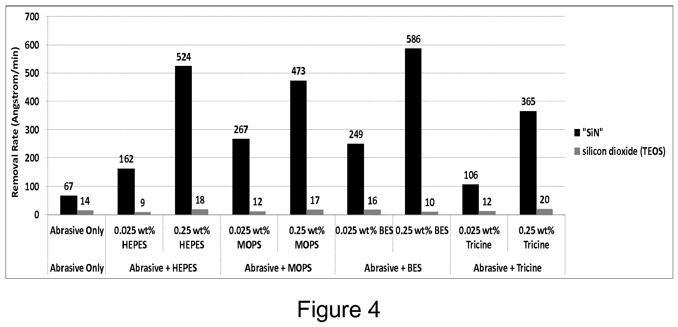

The removal rates were tunable by alternating the chemical additives used in the composition. For example, as shown in Figure 4, the use of HEPES, MOPS, BES and Tricine demonstrated the enhancement of "SiN" removal rate compared to control. In addition, HEPES, MOPS and BES provided greater "SiN" removal rate enhancement than Tricine compared to the control, showing the enhancement was tunable. In addition, the removal rate increase at 0.25wt% additive was higher than the removal rate increase at 0.025wt% additive.

The removal rates of "SiN" and TEOS films and the removal selectivities , shown as the ratio of removal rates of "SiN"/TEOS, using different additives at 0.025wt% or 0.25wt% were listed in Table 8.

**Table 8. The Chemical Additive Effects on Removal Rates of "SiN"**

| Additive Name | Type of Additive* | Additive Concentra tion (wt%) | RR of "SiN" Film (Angstrom/min) | RR of TEOS Film (Angstrom/min) | Selectivity of "SiN"/TEOS |
|---|---|---|---|---|---|
| Control | none | none | 67 | 14 | 4.8 |
| HEPES | Type I | 0.025 | 162 | 9 | 18 |
| | | 0.25 | 524 | 18 | 29.1 |
| MOPS | Type II | 0.025 | 267 | 12 | 22.3 |
| | | 0.25 | 473 | 17 | 27.8 |
| BES | Type III | 0.025 | 249 | 16 | 15.6 |
| | | 0.25 | 586 | 10 | 58.6 |
| Tricine | Type IV | 0.025 | 106 | 12 | 8.8 |
| | | 0.25 | 365 | 20 | 18.3 |

As shown in Table 8, the removal selectivities were all higher than the control when the chemical additives were used.

In summary, the CMP compositions containing chemical additives disclosed above demonstrated enhanced removal rates in polishing semiconductor substrates. The CMP compositions containing chemical additives also provided unexpected high selectivity for "SiC" removal compared to TEOS removal. In addition, The CMP compositions provided tunable selective polishing between "SiC"/"SiN", "SiC"/TEOS, "SiN"/TEOS.

The tunable selective polishing results are expected to be extended to "SiCₓN_{y}"/TEOS.

## Claims

1. A method of a selective chemical mechanical polishing comprising steps of:
a) providing a semiconductor substrate having a surface containing a first material selected from SiCₓN_{y} wherein x is in the range of 0.1wt% to 55wt%, and y is in the range of 0.1wt % to 32 wt%; SiC; and SiN;
and at least one second material selected from SiO₂ and SiN, wherein the first material is different from the second material;
b) providing a polishing pad;
c) providing a chemical mechanical polishing composition comprising:
A) 0.05 weight % to 30 weight % abrasive;
B) 0.025 weight % to 5 weight % chemical additive; and
C) liquid carrier;
wherein the chemical additive is selected from the group consisting of 4-morpholine derivatives having a general molecular structure of: 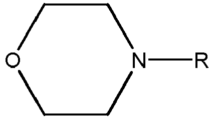 wherein R is selected from the group consisting of alkyl, alkoxy, optionally substituted organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester and organic amine; and combinations thereof; and
the pH of the chemical mechanical polishing composition is from 2 to 8;
d) contacting the surface of the semiconductor substrate with the polishing pad and the chemical mechanical polishing composition; and
e) polishing the surface of the semiconductor substrate to selectively remove the first material;
wherein at least a portion of the surface containing the first material is in contact with both the polishing pad and the chemical mechanical polishing composition; ratio of removal rate of the first material to removal rate of the second material is equal or greater than 1.

2. The method of Claim 1, wherein the chemical additive is selected from the group consisting of 3-(N-Morpholino)propanesulfonic acid (MOPS), 4-Morpholineethanesulfonic acid (MES) and β-Hydroxy-4-morpholinepropanesulfonic acid (MOPSO) and combinations thereof.

3. The method of Claim 1 or Claim 2, wherein the abrasive is selected from the group consisting of alumina, ceria, germania, silica, aluminum-doped silica, titania, zirconia, and mixtures thereof; and/or the liquid carrier is deionized water.

4. The method of any one of the preceding claims, wherein the chemical mechanical polishing composition further comprises:
0.005 weight % to 5.0 weight % of an oxidizing agent selected from the group consisting of one or more peroxy-compounds comprising at least one peroxy group (-O-O-); and/or up to 2.0 weight% of a pH buffering agent wherein the pH buffering agent used to lower the pH of the composition is optionally selected from the group consisting of hydrochloric acid, nitric acid, sulfuric acid, tartaric acid, succinic acid, citric acid, malic acid, malonic acid, fatty acids, polycarboxylic acids, and mixtures thereof; and
the pH buffering agent used to raise the pH of the composition is optionally selected from the group consisting of potassium hydroxide, sodium hydroxide, ammonia and mixtures thereof.

5. The method of Claim 4, wherein the peroxy-compound is hydrogen peroxide.

6. The method of any one of the preceding claims, wherein the chemical mechanical polishing composition further comprises 0.0001 weight % to 1 weight% of a surfactant; and/or 0.0001 weight % to 0.03 weight% of a biocide; wherein the surfactant is optionally selected from the group consisting of ethoxylated saturated and unsaturated alcohols.

7. The method of any one of the preceding claims, wherein the remainder of the chemical mechanical polishing composition in addition to abrasive; chemical additive; and optionally oxidizing agent, buffering agent, surfactant, biocide and polymer is liquid carrier.

8. A chemical mechanical polishing composition comprising:
a) 0.05 weight % to 30 weight % abrasive;
b) 0.025 weight % to 5 weight % chemical additive; and
c) liquid carrier;
wherein the chemical additive is β-Hydroxy-4-morpholinepropanesulfonic acid (MOPSO) and the pH of the chemical mechanical polishing composition is from 2 to 8.

9. The composition of Claim 8, wherein the abrasive is selected from the group consisting of alumina, ceria, germania, silica, aluminum-doped silica, titania, zirconia, and mixtures thereof; and/or the liquid carrier is deionized water.

10. The composition of Claim 8 or Claim 9 further comprising:
0.005 weight % to 5.0 weight % of an oxidizing agent selected from the group consisting of one or more peroxy-compounds comprising at least one peroxy group (-O-O-); and/or up to 2.0 weight% of a pH buffering agent wherein the pH buffering agent used to lower the pH of the composition is optionally selected from the group consisting of hydrochloric acid, nitric acid, sulfuric acid, tartaric acid, succinic acid, citric acid, malic acid, malonic acid, fatty acids, polycarboxylic acids, and mixtures thereof; and
the pH buffering agent used to raise the pH of the composition is optionally selected from the group consisting of potassium hydroxide, sodium hydroxide, ammonia and mixtures thereof.

11. The composition of Claim 10, wherein the peroxy-compound is hydrogen peroxide.

12. The composition of any one of Claims 8 to 11, further comprising 0.0001 weight % to 1 weight% of a surfactant; and/or 0.0001 weight % to 0.03 weight% of a biocide; wherein the surfactant is optionally selected from the group consisting of ethoxylated saturated and unsaturated alcohols.

13. The composition of any one of Claims 8 to 12, wherein the remainder of the composition in addition to abrasive; chemical additive; and optionally oxidizing agent, buffering agent, surfactant, biocide and polymer is liquid carrier.

## Patentansprüche

1. Verfahren eines selektiven chemisch-mechanischen Polierens, umfassend die folgenden Schritte:
a) Bereitstellen eines Halbleiter-Substrats mit einer Oberfläche, die ein erstes Material enthält, ausgewählt aus SiCₓN_{y} wobei x im Bereich von 0,1 Gew.-% bis 55 Gew.-% ist, und y im Bereich von 0,1 Gew.-% bis 32 Gew.-% ist; SiC; und SiN;
und mindestens ein zweites Material ausgewählt ist aus SiO₂ und SiN, wobei sich das erste Material von dem zweiten Material unterscheidet;
b) Bereitstellen eines Polier-Pads;
c) Bereitstellen einer chemisch-mechanischen Polierzusammensetzung, umfassend:
A) 0,05 Gewichts-% bis 30 Gewichts-% Schleifmittel;
B) 0,025 Gewichts-% bis 5 Gewichts-% chemisches Additiv; und
C) flüssigen Trägerstoff;
wobei das chemische Additiv ausgewählt ist aus der Gruppe bestehend aus 4-Morpholin-Derivaten, mit einer allgemeinen molekularen Struktur wie folgt: 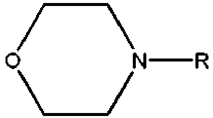 wobei R ausgewählt ist aus der Gruppe bestehend aus Alkyl, Alkoxy, einer optional substituierten organischen Gruppe mit einer oder mehreren Hydroxyl-Gruppen, einer optional substituierten organischen Sulfonsäure, einem optional substituierten organischen Sulfonsäuresalz, einer optional substituierten organischen Carbonsäure, einem optional substituierten organischen Carbonsäuresalz, einem organischen Carbonester und einem organischen Amin; und Kombinationen davon; und
der pH der chemisch-mechanischen Polierzusammensetzung von 2 bis 8 ist;
d) Inkontaktbringen der Oberfläche des Halbleiter-Substrats mit dem Polier-Pad und der chemisch-mechanischer Polierzusammensetzung; und
e) Polieren der Oberfläche des Halbleiter-Substrats, um selektiv das erste Material zu entfernen;
wobei mindestens ein Abschnitt der Oberfläche, die das erste Material enthält, in Kontakt mit dem Polier-Pad und der chemisch-mechanischen Polierzusammensetzung ist; das Verhältnis der Entfernungsrate des ersten Materials zur Entfernungsrate des zweiten Materials gleich wie oder größer als 1 ist.

2. Verfahren nach Anspruch 1, wobei das chemische Additiv ausgewählt ist aus der Gruppe bestehend aus 3-(N-Morpholino)propansulfonsäure (MOPS), 4-Morpholinethansulfonsäure (MES) und β-Hydroxy-4-morpholinpropansulfonsäure (MOPSO) und Kombinationen davon.

3. Verfahren nach Anspruch 1 oder Claim 2, wobei das Schleifmittel ausgewählt ist aus der Gruppe bestehend aus Tonerde, Ceroxid, Germaniumoxid, Siliciumoxid, Aluminium-dotiertes Siliciumoxid, Titanoxid, Zirkonoxid und Gemischen davon; und/oder der flüssige Trägerstoff entionisiertes Wasser ist.

4. Verfahren nach einem der vorherigen Ansprüche, wobei die chemisch-mechanische Polierzusammensetzung ferner folgendes umfasst:
0,005 Gewichts-% bis 5,0 Gewichts-% eines Oxidationsmittels, ausgewählt aus der Gruppe bestehend aus einer oder mehreren Peroxy-Verbindungen umfassend mindestens eine Peroxy-Gruppe (-O-O-); und/oder bis zu 2,0 Gewichts-% eines pH-Puffermittels, wobei das pH-Puffermittel, das verwendet wird, um den pH der Zusammensetzung zu senken, optional ausgewählt ist aus der Gruppe bestehend aus Salzsäure, Salpetersäure, Schwefelsäure, Weinsäure, Succinylsäure, Zitronensäure, Apfelsäure, Malonsäure, Fettsäuren, Polycarbonsäure und Gemischen davon; und
das pH-Puffermittel, das verwendet wird, um den pH der Zusammensetzung zu erhöhen, optional ausgewählt ist aus der Gruppe bestehend aus Kaliumhydroxid, Natriumhydroxid, Ammoniak und Gemischen davon.

5. Verfahren nach Anspruch 4, wobei die Peroxy-Verbindung Wasserstoffperoxid umfasst.

6. Verfahren nach einem der vorherigen Ansprüche, wobei die chemisch-mechanische Polierzusammensetzung ferner 0,0001 Gewichts-% bis 1 Gewichts-% eines Tensids umfasst; und/oder 0,0001 Gewichts-% bis 0,03 Gewichts-% eines Biozids; wobei das Tensid optional ausgewählt ist aus der Gruppe bestehend aus ethoxylierten gesättigten und ungesättigten Alkoholen.

7. Verfahren nach einem der vorherigen Ansprüche, wobei der Rest der chemisch-mechanischen Polierzusammensetzung zusätzlich zu Schleifmittel; chemischem Additiv; und optional Oxidationsmittel, Puffermittel, Tensid, Biozid und Polymer ein flüssiger Trägerstoff ist.

8. Chemisch-mechanische Polierzusammensetzung, umfassend:
a) 0,05 Gewichts-% bis 30 Gewichts-% Schleifmittel;
b) 0,025 Gewichts-% bis 5 Gewichts-% chemisches Additiv; und
c) flüssigen Trägerstoff;
wobei das chemische Additiv β-Hydroxy-4-morpholinpropansulfonsäure (MOPSO) ist, und der pH der chemisch-mechanischen Polierzusammensetzung von 2 bis 8 ist.

9. Zusammensetzung nach Anspruch 8, wobei das Schleifmittel ausgewählt ist aus der Gruppe bestehend aus Tonerde, Ceroxid, Germaniumoxid, Siliciumoxid, Aluminium-dotiertes Siliciumoxid, Titanoxid, Zirkonoxid und Gemischen davon; und/oder der flüssige Trägerstoff entionisiertes Wasser ist.

10. Zusammensetzung nach Anspruch 8 oder Claim 9, ferner umfassend:
0,005 Gewichts-% bis 5,0 Gewichts-% eines Oxidationsmittels, ausgewählt aus der Gruppe bestehend aus einer oder mehreren Peroxy-Verbindungen umfassend mindestens eine Peroxy-Gruppe (-O-O-); und/oder bis zu 2,0 Gewichts-% eines pH-Puffermittels, wobei das pH-Puffermittel, das verwendet wird, um den pH der Zusammensetzung zu senken, optional ausgewählt ist aus der Gruppe bestehend aus Salzsäure, Salpetersäure, Schwefelsäure, Weinsäure, Succinylsäure, Zitronensäure, Apfelsäure, Malonsäure, Fettsäuren, Polycarbonsäure und Gemischen davon; und
das pH-Puffermittel, das verwendet wird, um den pH der Zusammensetzung zu erhöhen, optional ausgewählt ist aus der Gruppe bestehend aus Kaliumhydroxid, Natriumhydroxid, Ammoniak und Gemischen davon.

11. Zusammensetzung nach Anspruch 10, wobei die Peroxy-Verbindung Wasserstoffperoxid ist.

12. Zusammensetzung nach einem der Ansprüche 8 bis 11, ferner umfassend 0,0001 Gewichts-% bis 1 Gewichts-% eines Tensids; und/oder 0,0001 Gewichts-% bis 0,03 Gewichts-% eines Biozids; wobei das Tensid optional ausgewählt ist aus der Gruppe bestehend aus ethoxylierten gesättigten und ungesättigten Alkoholen.

13. Zusammensetzung nach einem der Ansprüche 8 bis 12, wobei der Rest der Zusammensetzung zusätzlich zu Schleifmittel; chemischem Additiv; und optional Oxidationsmittel, Puffermittel, Tensid, Biozid und Polymer flüssiger Trägerstoff ist.

## Revendications

1. Procédé de polissage chimico-mécanique sélectif comprenant les étapes consistant à :
a) fournir un substrat semi-conducteur ayant une surface contenant un premier matériau sélectionné entre SiCₓN_{y}, où x est dans la gamme de 0,1 % en poids à 55 % en poids, et y est dans la gamme de 0,1 % en poids à 32 % en poids ; SiC ; et SiN ;
et au moins un deuxième matériau sélectionné entre SiO₂ et SiN, le premier matériau étant différent du deuxième matériau ;
b) fournir un tampon de polissage ;
c) fournir une composition de polissage chimico-mécanique comprenant :
A) 0,05 % en poids à 30 % en poids d'abrasif ;
B) 0,025 % en poids à 5 % en poids d'un additif chimique ; et
C) un véhicule liquide ;
l'additif chimique étant sélectionné dans le groupe comprenant des dérivés de 4-morpholine ayant une structure moléculaire générale de : 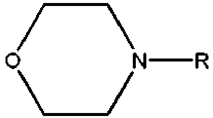 où R est sélectionné dans le groupe constitué de : alkyle, alkoxy, groupe organique optionnellement substitué avec un ou plusieurs groupes hydroxyle, acide sulfonique organique optionnellement substitué, sel d'acide sulfonique organique optionnellement substitué, acide carboxylique organique optionnellement substitué, sel d'acide carboxylique organique optionnellement substitué, ester carboxylique organique et amine organique ; et des combinaisons de ceux-ci ; et
le pH de la composition de polissage chimico-mécanique est de 2 à 8 ;
d) mettre en contact la surface du substrat semi-conducteur avec le tampon de polissage et la composition de polissage chimico-mécanique ; et
e) polir la surface du substrat semi-conducteur pour enlever sélectivement le premier matériau ;
dans lequel au moins une partie de la surface contenant le premier matériau est en contact à la fois avec le tampon de polissage et la composition de polissage chimico-mécanique ; le rapport du taux d'enlèvement du premier matériau au taux d'enlèvement du deuxième matériau étant égal ou supérieur à 1.

2. Procédé selon la revendication 1, dans lequel l'additif chimique est sélectionné dans le groupe constitué de : acide 3-(N-morpholino)propanesulfonique (MOPS), acide 4-morpholineéthanesulfonique (MES) et acide β-hydroxy-4-morpholinepropanesulfonique (MOPSO) et des combinaisons de ceux-ci.

3. Procédé selon la revendication 1 ou la revendication 2, dans lequel l'abrasif est sélectionné dans le groupe constitué de : alumine, céria, germania, silice, silice dopée à l'aluminium, dioxyde de titane, zirconia, et des mélanges de ceux-ci ; et/ou le véhicule liquide est l'eau déionisée.

4. Procédé selon l'une quelconque des revendications précédentes, dans lequel la composition de polissage chimico-mécanique comprend en outre :
0,005 % en poids à 5,0 % en poids d'un agent oxydant sélectionné dans le groupe constitué de : un ou plusieurs composés péroxy comprenant au moins un groupe péroxy (-O-O-) ; et/ou jusqu'à 2,0 % en poids d'un tampon de pH, l'agent tampon de pH utilisé pour abaisser le pH de la composition étant optionnellement sélectionné dans le groupe constitué de : acide chlorhydrique, acide nitrique, acide sulfurique, acide tartrique, acide succinique, acide citrique, acide malique, acide malonique, acides gras, acides polycarboxyliques et des mélanges de ceux-ci ; et
le tampon de pH utilisé pour élever le pH de la composition étant optionnellement sélectionné dans le groupe comprenant : hydroxyde de potassium, hydroxyde de sodium, ammoniac et des mélanges de ceux-ci.

5. Procédé selon la revendication 4, dans lequel le composé péroxy est le peroxyde d'hydrogène.

6. Procédé selon l'une quelconque des revendications précédentes, dans lequel la composition de polissage chimico-mécanique comprend en outre 0,0001 % en poids à 1 % en poids d'un surfactant ; et/ou 0,0001 en poids à 0,03 % en poids d'un biocide, le surfactant étant optionnellement sélectionné dans le groupe constitué d'alcools saturés et insaturés éthoxylés.

7. Procédé selon l'une quelconque des revendications précédentes, dans lequel le reste de la composition de polissage chimico-mécanique, outre l'abrasif, l'additif chimique et optionnellement l'agent oxydant, le tampon, le surfactant, le biocide et le polymère, est un véhicule liquide.

8. Composition de polissage chimico-mécanique comprenant :
a) 0,05 % en poids à 30 % en poids d'abrasif ;
b) 0,025 % en poids à 5 % en poids d'additif chimique ; et
c) un véhicule liquide ;
l'additif chimique étant l'acide β-hydroxy-4-morpholinepropanesulfonique (MOPSO) et le pH de la composition de polissage chimico-mécanique étant de 2 à 8.

9. Composition selon la revendication 8, dans laquelle l'abrasif est sélectionné dans le groupe constitué de : alumine, céria, germania, silice, silice dopée à l'aluminium, dioxyde de titane, zirconia et des mélanges de ceux-ci ; et/ou le véhicule liquide est l'eau déionisée.

10. Composition selon la revendication 8 ou la revendication 9, comprenant en outre :
0,005 % en poids à 5,0 % en poids d'un agent oxydant sélectionné dans le groupe constitué de : un ou plusieurs composés péroxy comprenant au moins un groupe péroxy (-O-O-) ; et/ou jusqu'à 2,0 % en poids d'un tampon de pH, le tampon de pH utilisé pour abaisser le pH de la composition étant optionnellement sélectionné dans le groupe constitué de : acide chlorhydrique, acide nitrique, acide sulfurique, acide tartrique, acide succinique, acide citrique, acide malique, acide malonique, acides gras, acides polycarboxyliques, et des mélanges de ceux-ci ; et
le tampon de pH utilisé pour élever le pH de la composition étant optionnellement sélectionné dans le groupe constitué de : hydroxyde de potassium, hydroxyde de sodium, ammoniac et des mélanges de ceux-ci.

11. Composition selon la revendication 10, dans laquelle le composé péroxy est le peroxyde d'hydrogène.

12. Composition selon l'une quelconque des revendications 8 à 11, comprenant en outre 0,0001 % en poids à 1 % en poids d'un surfactant ; et/ou 0,0001 % en poids à 0,03 % en poids d'un biocide ; le surfactant étant optionnellement sélectionné dans le groupe constitué d'alcools saturés et insaturés éthoxylés.

13. Composition selon l'une quelconque des revendications 8 à 12, dans laquelle le reste de la composition, outre l'abrasif, l'additif chimique et optionnellement l'agent oxydant, le tampon, le surfactant, le biocide et le polymère est un véhicule liquide.
